Europäisches Patentamt

European Patent Office

Office européen des brevets

(19)

(11) Numéro de publication: **0 155 856**
**B1**

(12) **FASCICULE DE BREVET EUROPÉEN**

(45) Date de publication du fascicule du brevet:
08.06.88

(21) Numéro de dépôt: **85400103.9**

(22) Date de dépôt: **23.01.85**

(51) Int. Cl.⁴: **H 05 K 5/00,** H 05 K 7/14

(54) Cellule modulaire de support et de protection de cartes électroniques.

(30) Priorité: **08.02.84 FR 8401915**

(43) Date de publication de la demande:
**25.09.85 Bulletin 85/39**

(45) Mention de la délivrance du brevet:
**08.06.88 Bulletin 88/23**

(84) Etats contractants désignés:
**BE DE GB IT NL SE**

(56) Documents cité:
**GB-A-1 597 829**
**GB-A-2 021 869**
**US-A-3 258 649**
**US-A-3 603 845**

(73) Titulaire: **LA TELEMECANIQUE ELECTRIQUE, 33
bis, avenue du Maréchal Joffre, F-92000 Nanterre
(FR)**

(72) Inventeur: **Lerude, Gérard, Chemin du Puy La
Vigie Parc Maré Polis, F-06600 Antibes (FR)**
Inventeur: **Roux, Christine, Quartier le Collet Opio,
F-06650 Le Rouret (FR)**

(74) Mandataire: **Marquer, Francis, CABINET
MOUTARD 35, avenue Victor Hugo Résidence
Champfleury, F-78180 Voisins- le- Bretonneux (FR)**

LIBER, STOCKHOLM 1988

## Description

La présente invention concerne une cellule modulaire de support et de protection de cartes électroniques utilisable notamment, mais non exclusivement, à la réalisation de structures alvéolaires porte-cartes telles que, par exemple, celle qui se trouve décrite dans le brevet EP-A-0 154 570.

D'une manière générale, on sait qu'il est connu de réaliser des dispositifs électroniques multicartes par juxtaposition et assemblage éventuel de cellules modulaires contenant chacune une carte électronique. Ces cellules peuvent consister en des boîtiers formés en une ou plusieurs parties, à l'intérieur desquels sont disposées les cartes. Par le brevet US-A-3 603 845, on a également proposé des cellules présentant des structures support comprenant chacune deux parois opposées sur lesquelles sont ménagées deux glissières respectives dans lesquelles la carte vient s'engager par coulissement et est ensuite fixée en position au moyen de dispositifs de fixation prévus sur lesdites parois. Bien entendu, ces cellules sont adaptées pour permettre l'implantation de connecteurs ou de borniers sur les bordures avant et/ou éventuellement arrière des cartes et le passage des connexions correspondantes. Elles doivent en outre être conçues avec précision pour garantir de bonnes conditions d'interconnexion et d'assemblage, ce qui, en conséquence, augmente considérablement leur coût de fabrication et augmente le temps de montage.

L'invention a donc pour but de supprimer ces inconvénients. Elle propose une cellule modulaire de conception simple, facilement réalisable en grande série en un matériau peu coûteux et, par conséquent, d'un prix de revient peu élevé.

Cette cellule modulaire de support et de protection de cartes électroniques comprend plus particulièrement, d'une part, un élément plat ou flan présentant deux bordures latérales parallèles, une bordure antérieure et une bordure postérieure et, d'autre part, s'étendant perpendiculairement audit flan, à partir de sa bordure postérieure et de ses deux bordures latérales, un fond et deux côtés latéraux, munis de moyens de guidage des cartes formant deux glissières respectives mutuellement en regard, parallèles au flan et faiblement distantes de celui-ci, l'écartement de ces deux glissières étant prévu de manière à ce que les cartes puissent y être engagées par deux de leurs bordures latérales opposées et puissent y coulisser, ladite cellule comprenant en outre des moyens de fixation permettant un maintien en position de la carte, une fois que la carte est parvenue en position d'utilisation à l'intérieur de la cellule, en fin de coursé de coulissement dans lesdits moyens de guidage.

Selon l'invention, cette cellule est plus particulièrement caractérisée en ce que ces moyens de fixation comprennent des moyens d'encliquetage prévus sur le flan, et coopérant avec des moyens d'encliquetage correspondants prévus ou rapportés sur la carte, ces moyens d'encliquetage étant conçus de manière à assurer un autocentrage et une fixation de la carte sur le flan.

Il s'avère donc que le flan utilisé dans la cellule précédemment décrite présente de multiples fonctions :

- il sert à assurer la protection de la face de la carte où sont effectuées les soudures,

il sert de support au fond et aux côtés latéraux de la cellule sur lesquels sont prévues les glissières,

- il sert à assurer un positionnement précis de la carte à l'intérieur de la cellule, en combinaison avec les susdits moyens de fixation.

Cette dernière fonction est particulièrement importante puisqu'elle permet, à elle seule, d'obtenir un auto-alignement de la carte et de ses connecteurs avant et arrière et, qu'en conséquence, elle réduit considérablement les contraintes de précision, notamment des côtés latéraux supportant les glissières et assure l'élimination des jeux en fin d'assemblage.

Grâce à cette réduction des contraintes de précision, elle permet la réalisation d'une cellule dans laquelle les côtés latéraux sont raccordés aux bordures latérales du flan au moyen de liaisons formant charnières.

Cette structure est particulièrement avantageuse dans le cas où la cellule est réalisée en matière plastique moulée. Dans ce cas, le flan et les deux côtés latéraux de la cellule sont moulés à plat, seul le fond s'étendant perpendiculairement au flan. Le moule utilisé est donc considérablement simplifié. Une fois le moulage effectué, les deux côtés latéraux sont rabattus à 90°C autour des liaisons formant charnières pour amener la cellule à sa forme définitive. Le maintien des côtés latéraux perpendiculairement au flan peut alors être assuré au moyen d'un dispositif d'encliquetage prévu entre le fond et la bordure latérale des côtés latéraux adjacents audit fond et éventuellement au moyen de surfaces de butée prévues entre lesdits côtés latéraux et ledit flan.

Les liaisons formant charnières prévues entre les côtés latéraux et le flan ne nécessitent pas une grande précision pour les raisons précédemment indiquées. Elles peuvent donc simplement consister en des pattes de liaison flexibles venues de moulage ou en des lignes de moindre épaisseur.

Bien entendu, le fond de la cellule peut comprendre au moins une fenêtre de passage pour un connecteur arrière enfichable sur les connexions arrière de la carte. Pour permettre un préréglage des connecteurs arrière, ces fenêtres de passage peuvent présenter une largeur supérieure à celle des connecteurs. La face arrière du fond peut en outre présenter, au droit de la fenêtre, des surfaces d'appui pour des faces correspondantes du connecteur, tandis qu'il est prévu de l'arrière de la cellule des moyens d'immobilisation du connecteur, par exemple du type à lame élastique emboîtable ou encliquetable. Cette disposition permet notamment une mémorisation de la position de premier enfichage du connecteur sur la carte préalablement fixée dans la cellule.

La cellule précédemment décrite peut en outre comprendre un blindage constitué par une pièce en tôle métallique présentant une face plane sensiblement aux dimensions du susdit flan et destiné à venir recouvrir celui-ci et deux ailes latérales repliées à angle droit sensiblement et destiné à venir en retour contre les susdits côtés latéraux.

Ce blindage destiné à assurer une protection électrique de carte logée dans la cellule assure en outre la rigidité et la protection mécanique de la cellule. Il comprend des moyens de fixation par exemple par encliquetage de la cellule, ainsi que des moyens d'assemblage mâle et femelle permettant l'emboîtement rigide de cellules adjacentes pour la réalisation de structures alvéolaires porte-cartes.

Les avantages ainsi que les particularités de l'invention apparaîtront clairement à la lumière de la description ci-après d'un mode d'exécution de l'invention donné à titre d'exemple non limitatif, avec référence aux dessins annexés dans lesquels:

La figure 1 représente en perspective un mode de réalisation d'une structure alvéolaire à trois cellules modulaires appelées ci-après alvéoles réalisée à l'aide de cellules guide-carte selon l'invention.

La figure 2 représente une partie de la même structure vue en perspective.

La figure 3 montre, en perspective, une cellule guide-carte utilisée dans la structure représentée figure 1.

La figure 4 montre la face arrière du fond de la même cellule.

La figure 5 représente un détail de la tranche d'une carte utilisable dans une cellule selon l'invention.

La figure 6 est une vue en perspective arrière d'une embase de tête.

La figure 7 représente, en perspective avant, le blindage d'une cellule.

Les figures 8 et 9 montrent un ensemble de connexion arrière et une lame d'immobilisation de cet ensemble.

La figure 10 représente, en perspective arrière, une variante de réalisation de l'embase de tête.

La figure 11 est une vue en coupe partielle d'une structure alvéolaire au droit des fenêtres de connexion.

La structure alvéolaire porte-cartes électroniques 100 représentée sur les figures comprend une embase de tête 110 et plusieurs alvéoles 130 munies chacune d'une cellule guide-carte isolante 300, chaque cellule étant revêtue d'un blindage métallique 200 et étant apte à recevoir une carte électronique 400.

Les alvéoles sont assemblées entre elles pour constituer un ensemble rigide multicartes, par exemple un automate programmable, cet ensemble étant fixé latéralement ou par sa partie arrière à un support, par exemple à un profilé normalisé 140 ou à une platine. Chaque alvéole reçoit sur sa face avant un bornier 150.

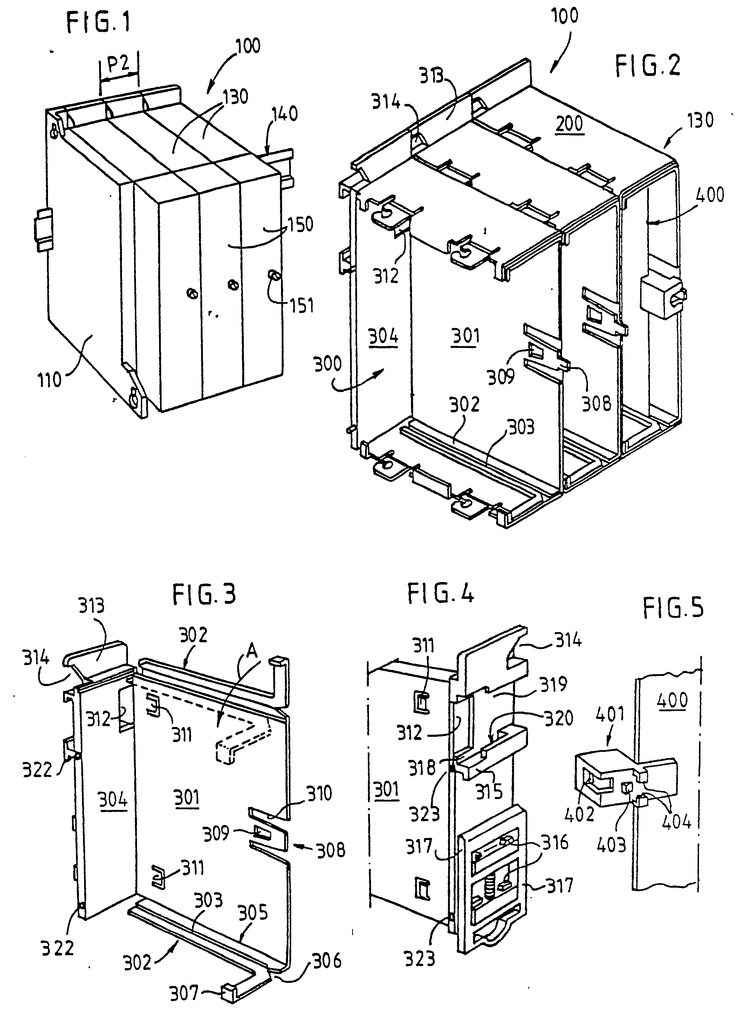

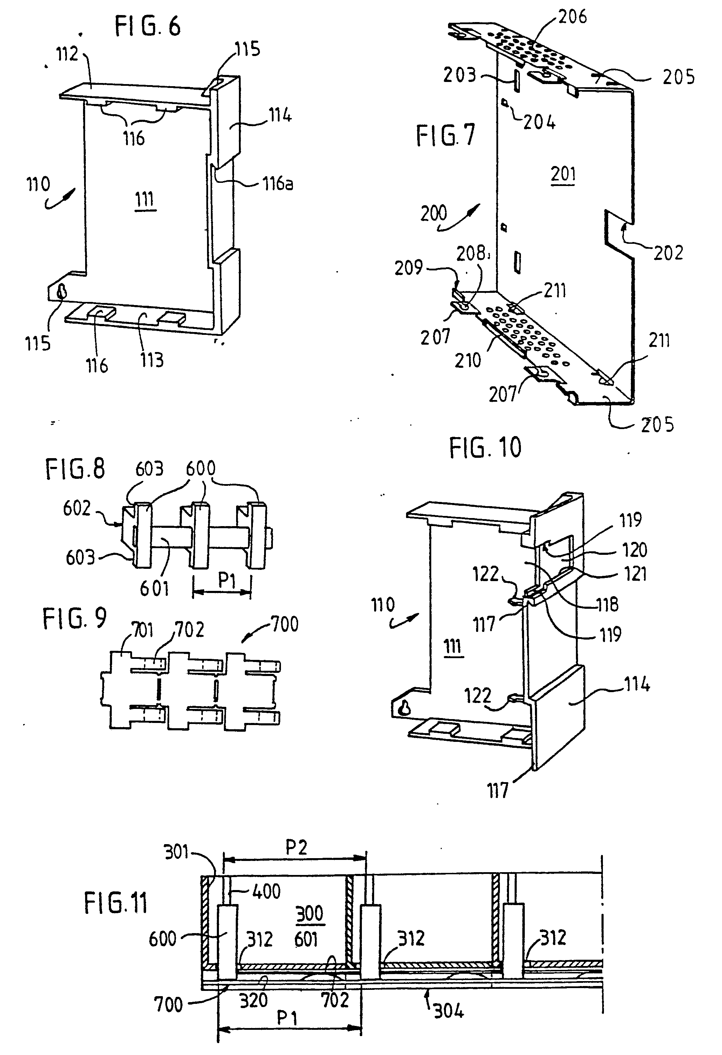

La cellule guide-carte 300 est moulée d'une pièce pour prendre la forme visible figure 2 ; elle est maintenue par emboîtement et protégée dans le blindage métallique 200 (figure 7) et constitue, en même temps qu'un logement pour la carte 400, un moyen de fixation de, la carte et de son bornier avant 150 et un moyen de positionnement mutuel de la carte et de son connecteur arrière 600.

La cellule guide-carte 300 comporte (figures 2 à 4) un élément plat ou flan 301 de protection de la face soudure de la carte électronique, deux côtés latéraux ou rabats en L, 302, munis de glissières 303 pour la carte, ainsi qu'un fond 304 destiné à former un socle arrière de fixation. Les rabats 302 sont reliés au flan 301 par des lignes d'articulation 305 formant charnières, tandis que les glissières 303 débouchent vers l'avant par des ouvertures en V, 306 ; la petite branche du L de chaque rabat présente un redan 307.

Les rabats 302 sont pliés comme le montre la flèche A de la figure 3 pour venir occuper la position indiquée en tirets pour le rabat supérieur et en traits pleins pour le rabat inférieur. Il est prévu un encliquetage ou autre moyen pour fixer les rabats 302 sur le fond 304.

Le flan 301 comprend de plus une languette élastique 308 munie d'un évidement 309, la languette et l'évidement ayant une forme en V convergente vers l'avant, la languette étant située dans un dégagement frontal 310 prévu dans la tranche du flan.

Dans la partie postérieure du flan sont ménagés des cliquets élastiques 311 dont le rôle sera expliqué plus loin.

Le fond ou socle 304 de la cellule guide-carte 300 présente une fenêtre 312 de libre passage pour le connecteur 600 associé à la cellule, cette fenêtre présentant une largeur et une hauteur supérieures à celles du connecteur pour permettre un débattement latéral de celui-ci. Le fond 304 comprend de plus une oreille supérieure 313 à encoche latérale de fixation 314, ainsi qu'a l'arrière (figure 4) une saillie rainurée 315 d'accrochage sur rail normalisé et des guides 316 permettant de recevoir un cliquet coulissant 317 de verrouillage de la cellule guide-carte sur le rail. La cellule guide-carte peut ainsi être fixée directement soit sur un rail, soit sur un support quelconque au moyen d'une vis engagée dans l'évidement 314 fermé par l'oreille d'une alvéole voisine ou par l'embase (figure 2).

Sur la face arrière du fond 304, la cellule guide-carte présente au droit de la fenêtre 312 des faces d'appui 318 pour des faces coopérantes du connecteur 600 et un logement échancré 319 définissant des encoches 320 afin de recevoir des moyens d'immobilisation du connecteur qui seront décrits plus loin.

Des éléments complémentaires de centrage, à savoir des pions 322 et des trous 323, sont prévus respectivement de part et d'autre du fond 304 sur les faces latérales de celui-ci pour permettre l'assemblage entre alvéoles ou entre alvéole et embase.

Le blindage métallique 200 visible sur les figures 2 et 7 a une section en U dont l'âme 201 présente une ouverture 202 correspondant sensiblement au dégagement 310 prévu dans la cloison latérale 301 de la cellule guide-carte associée, ainsi que des ouvertures 203 et 204. Les ouvertures 203 constituent des prises des cliquets 311 de la cellule guide-carte, tandis que les ouvertures 204 reçoivent le cas échéant les cliquets de l'embase. Les ailes 205 du blindage en U présentent des perforations régulières 206, des pattes 207 à fentes 208 formant crochets et des plis 209, 210 de raidissement et de butée notamment pour le redan 307 du rabat en L de la cellule guide-carte.

Des fentes 211 sont ménagées par crevé aux plis du U tandis que les pattes 207 sont situées dans des plans décalés vers l'intérieur par rapport aux plans des ailes 205 du blindage ; on assemble donc deux alvéoles adjacentes par introduction des pattes 207 du blindage de l'une dans les fentes 211 des pattes du blindage de l'autre puis glissement perpendiculaire relatif des blindages pour engager les fentes 208 de l'un sur l'âme 201 de l'autre.

Sur la tranchée antérieure de chaque carte 400 est disposé un bloc de fixation 401 (figure 5) muni vers l'avant d'un écrou prisonnier ou d'un orifice taraudé 402 pour la fixation d'une vis 151 prévue sur le bornier associé 150, et muni latéralement d'un cliquet ou autre élément de verrouillage 403 conçu pour coopérer avec l'évidement 309 de la languette élastique 308 de la cellule guide-carte.

Deux saillies de guidage 404 sont prévues sur le côté du bloc 401 pour guider la languette élastique 308 lorsqu'on introduit la carte dans l'alvéole. La longueur de l'évidement 309 est telle que celui-ci reçoit le cliquet 403 avec jeu, la mise en butée de la carte s'obtenant grâce à la vis 151 du bornier 150 comme il sera décrit par la suite.

L'embase de tête 110 en métal moulé est agencée pour loger l'alimentation du dispositif multicartes et, quand ce dispositif est un automate, pour loger l'unité centrale de ce dernier ; elle présente une paroi plane 111, deux côtés latéraux 112, 113 et un fond 114. La paroi plane 111 présente des orifices 115 de fixation utilisables dans le cas d'une pose de la structure alvéolaire sur un support latéral. Chaque côté latéral 112, 113 comprend deux fourreaux 116 agencés pour l'accrochage des pattes de fixation 207 du blindage de l'alvéole mitoyenne. Le fond présente des moyens 116a d'engagement et/ou de fixation par vissage ou encliquetage sur un support ; la tranche de ce fond est munie d'éléments de centrage 117 du côté de l'alvéole à fixer.

Dans le mode de réalisation de la figure 10, l'embase métallique de tête doit recevoir, outre une alimentation régulée, une unité centrale d'automate ; en vue d'assurer la connexion d'une carte non dessinée, elle présente une fenêtre 118 de passage pour un connecteur 600, des faces d'appui 119 pour les faces correspondantes du connecteur et un logement à échancrure 120 définissant des encoches 121 pour des moyens d'immobilisation du connecteur ; les éléments 119, 121 de l'embase ont des fonctions similaires à ceux 318, 320 des faces arrière des alvéoles.

Des cliquets 122 sont disposés pour coopérer avec les ouvertures 203 du blindage 200 complétant cette alvéole de base.

L'ensemble de connexion représenté sur les figures 8 et 9 regroupe les connecteurs 600 sur un même bus multiconducteur à nappe ou à câble plat 601, le pas minimum P1 entre connecteurs étant supérieur au pas P2 maximum des alvéoles. Chaque connecteur a une forme de T et présente une face antérieure de connexion 602 et sur les ailes du T des faces antérieures d'appui 603 agencées pour coopérer avec les faces 119 de l'embase. Un organe de fixation et de blindage 700 (figure 9) associé à l'ensemble de connexion comprend une lame de tôle découpée et mise en forme de manière à présenter des saillies latérales 701 et des doigts de pression 702, cette lame servant à bloquer les connecteurs après enfichage de ceux-ci sur les cartes.

Le dispositif décrit s'assemble de la manière suivante. La cellule guide-carte 300 de chaque alvéole est moulée et repliée comme déjà décrit, puis emboîtée dans un blindage 200, les cliquets 311 de la cellule n'étant pas encore engagés dans les ouvertures 203 du blindage ; les pattes 207 du blindage dépassent de la cellule. L'alvéole de base est alors assemblée à l'embase 110 par engagement des pions de centrage 322 dans les trous correspondants 117 de l'embase, puis par poussée du blindage pour en provoquer la translation vers l'arrière jusqu'à encliquetage des pattes 207 dans les fourreaux 116 et butée du blindage sur le fond 304 de la cellule guide-carte; il convient de noter qu'au cours de la translation du blindage, les cliquets 311 s'engagent dans les ouvertures 203 pour empêcher désormais tout mouvement relatif de la cellule par rapport au blindage.

La deuxième alvéole est assemblée de même à la première et la troisième à la deuxième. La structure modulaire est donc extérieurement résistante et rigide grâce à l'encliquetage des blindages, ce qui assure leur liaison électrique tout en assurant intérieurement une souplesse d'introduction et de connexion des cartes électroniques. Il découle du mode d'assemblage décrit que le nombre d'alvéoles constituant un même assemblage n'est pas limité. On introduit dans chaque cellule 130 la carte électronique correspondante 400 par glissement de la carte dans les glissières 303 ; en fin d'introduction, l'extrémité de la languette 308 de la cellule guide-carte s'engage dans les saillies de guidage 404 du bloc 401 solidaire de la carte et le cliquet 403 pénètre dans l'évidement 309 en V de la languette, la longueur de l'évidement laissant subsister une certaine liberté de translation de la carte.

Le bornier 150 est alors mis en place sur l'alvéole 130 et l'on fait tourner sa vis de fixation 151 dans l'écrou prisonnier 402 du bloc 401 ; le bornier prend appui sur la face avant de la cellule 130 et le vissage de la vis 151 a dès lors pour effet de tirer vers l'avant la carte 400 jusqu'à ce que le cliquet 403 bute sur les côtés du V de l'évidement 309, ce qui centre et immobilise la carte par rapport à sa cellule de réception.

L'ensemble de connexion comprenant le câble plat et les trois connecteurs 600 est ensuite approché de la face arrière de la structure modulaire et les connecteurs sont introduits par les fenêtres 312 des alvéoles et éventuellement la fenêtre 118 de l'embase (dans le mode de réalisation de la figure 10) et enfichés sur les zones encartables ou les connecteurs arrière des cartes 400, jusqu'à prise d'appui des faces 603 des connecteurs sur les faces 318, 119 des alvéoles ou de l'embase.

La lame 700 est mise en place sur le dos des connecteurs et ses saillies 701 sont engagées dans le logement à échancrures 319, 120 et les doigts de pression 702 prenant appui sur la face arrière 603 de chaque connecteur 600. Il s'ensuit que la lame de blindage immobilise chaque connecteur 600 dans sa position d'autocentrage par rapport à la carte préalablement immobilisée et donc à la cellule guide-carte correspondante.

Il résulte de la description ci-dessus que la cellule guide-carte 300, rendue rigide par l'adjonction du blindage correspondant 200, joue le rôle de référence de position à la fois pour la carte 400 via les glissières 303 et l'évidement d'encliquetage 309 pour le bornier 150 via la vis 151, l'écrou prisonnier 402 et l'encliquetage 309, 403, pour le bornier arrière via la carte 400 et les faces d'appui 318. L'autocentrage des connecteurs arrière sur les cartes déjà immobilisées élimine les contraintes habituelles d'alignement des connecteurs par rapport aux guide-cartes vides.

L'échange d'une carte 400 défectueuse s'effectue par dévissage de la vis 151 du bornier 150, débrochage du bornier restant lié à l'alvéole par une lanière de maintien, déblocage de la carte par l'écartement de la languette 308 puis extraction de la carte de préférence par prise du bloc 401. La carte de remplacement se glisse dans les glissières 303, se connecte en fin de course sur le connecteur arrière 600, se fixe comme précédemment par l'encliquetage 309, 403, et se verrouille après remise en place du bornier 150 par le vissage de la vis 151.

**Revendications**

1. Cellule modulaire de support et de protection de cartes électroniques comprenant, d'une part, un élément plat ou flan (301) présentant deux bordures latérales parallèles, une bordure antérieure et une bordure postérieure et, d'autre part, s'étendant perpendiculairement audit flan à partir de sa bordure postérieure et de ses deux bordures latérales, respectivement un fond (304) et deux côtés latéraux (302) munis de moyens de guidage des cartes formant deux glissières respectives (303), mutuellement en regard, parallèles au flan (301) et faiblement distantes de celui-ci, l'écartement de ces deux glissières (303) étant prévu de manière à ce que les cartes puissent y être engagées par deux de leurs bordures latérales opposées et puissent y coulisser, et comprenant des moyens de fixation permettant le maintien en position de la carte, une fois que la carte est parvenue en position d'utilisation à l'intérieur de la cellule, en fin de course de coulissement dans lesdites glissières (303), caractérisée en ce que les moyens de fixation comprennent des moyens d'encliquetage (309) prévus sur le flan (301) et coopérant avec des moyens d'encliquetage (403) correspondants prévus ou rapportés sur la carte (400), les moyens d'encliquetage (309, 403) étant conçus de manière à assurer un autocentrage et une fixation en position de la carte sur le flan.

2. Cellule selon la revendication 1, caractérisée en ce que les moyens d'encliquetage (309), (403) sont constitués par un cliquet (403) prévu sur un bloc (401) de fixation rapporté sur la carte et par un évidement (309) de forme correspondante, prévu dans le flan (301) de la cellule.

3. Cellule selon la revendication 2, caractérisée en ce que :
- l'un des moyens d'encliquetage (309, 403) présente une forme convergente vers l'avant, et
- le bloc de fixation (401) comprend un filetage (402) prévu pour coopérer avec une vis (151) de fixation d'un bornier (150) associé à la cellule (130), le filetage (402) étant positionné par rapport à la carte de façon que le serrage de la vis (151) permette la prise d'une butée arrière du bornier contre la cellule et la mise en butée avant de la carte contre la cellule.

4. Cellule selon l'une des revendications précédentes, caractérisée en ce que ledit fond (304) comprend au moins une fenêtre (312) de passage pour un connecteur arrière enfichable (600) sur les connexions arrière de la carte, la face arrière du fond présentant au droit de la fenêtre (312) des surfaces d'appui pour des faces correspondantes du connecteur arrière (600), ainsi que des moyens d'immobilisation dudit connecteur arrière (600).

5. Cellule selon la revendication 4, caractérisée en ce que la fenêtre de passage (312) ménagée dans le fond (304) a une largeur et une hauteur supérieures à celle du connecteur arrière (600), et en ce que les susdits moyens d'immobilisation sont conçus pour immobiliser le connecteur arrière après enfichage de celui-ci sur la carte (400).

6. Cellule selon l'une des revendications 4 et 5, caractérisée en ce que les susdits moyens d'immobilisation sont constitués par une lame élastique (700) de pression susceptible d'être engagée dans un logement à échancrure (319, 120) de la face arrière de la cellule.

7. Cellule selon l'une des revendications 4 à 6, caractérisée en ce que le connecteur arrière (600) est monté sur un bus plat multiconducteur (601).

8. Celllule selon l'une des revendications précédentes, caractérisée en ce que les susdits côtés latéraux (302) sont raccordés aux bordures latérales du flan (301) au moyen de liaisons (305) formant charnières.

9. Cellule selon la revendication 8, caractérisée en ce qu'elle est réalisée en matière plastique moulée, et en ce que les susdites liaisons formant charnières (305) consistent en des pattes de liaison flexibles venues de moulage ou en des lignes de moindre épaisseur.

10. Cellule selon l'une des revendications 6 et 7, caractérisée en ce que le maintien des côtés latéraux (302) perpendiculairement au flan est assuré au moyen d'un dispositif d'encliquetage prévu entre le fond (304) et les bordures latérales des côtés latéraux adjacents audit fond (304).

11. Cellule selon l'une des revendications précédentes, caractérisée en ce qu'elle comprend en outre un blindage (200) constitué par une pièce en tôle métallique présentant une face plane (201) venant recouvrir ledit flan (301) et deux ailes latérales repliées à angle droit venant en retour sur les susdits côtés latéraux (302), ce blindage (200) comprenant en outre des moyens permettant l'assemblage par coulissement de ladite cellule.

12. Cellule selon l'une des revendications 11 et 12, caractérisée en ce que la face plane du blindage (200) comporte des découpes dans lesquelles viennent s'encliqueter en fin d'assemblage des cliquets (311) prévus sur la face extérieure du susdit flan.

**Patentansprüche**

1. Elektronische Karten tragende und schützende Moduleinheit mit, einerseits einem flachen Element oder Plättchen (301), welches zwei parallele Seitenränder, einen vorderen und einen hinteren Rand aufweist, und, andererseits, senkrecht im Verhältnis zu besagtem Plättchen ausgerichtet, von seinem hinteren Rand und seinen beiden Seitenrändern ausgehend, jeweils einem Bodenteil (304) und zwei Seitenteilen (302), die mit Kartenführungsmitteln versehen sind, welche zwei einander gegenüberliegende, zum Plättchen (301) parallel und in geringem Abstand von diesem angeordnete Führungen (303) bilden, wobei der Abstand zwischen besagten beiden Führungen (303) so bestimmt ist, dass die Karten mit zweien ihrer gegenüberliegenden Seitenränder eingeführt werden und in ihnen gleiten können, und mit Befestigungsmitteln, um die Karte in Position zu halten, wenn sie im Inneren der Einheit am Ende ihrer Gleitbahn in besagten Führungen (303) ihre Einsatzstellung erreicht hat, dadurch gekennzeichnet, dass die Befestigungsmittel auf dem Plättchen (301) angeordnete Sperrmittel (309) aufweisen, die mit den entsprechenden auf der Karte (400) vorgehenen oder angebrachten Sperrmitteln (403) zusammenarbeiten, wobei die Sperrmittel (309, 403) so ausgebildet sind, dass eine Selbstzentrierung und Halterung in der vorgegebenen Stellung der Karte auf dem Plättchen erreicht wird.

2. Einheit nach Anspruch 1, dadurch gekennzeichnet, dass die Sperrmittel (309, 403) von einer Sperrklinke (403) gebildet werden, die auf auf einer auf der Karte befestigten Befestigungsvorrichtung (401) vorgesehen sind und von einer entsprechend geformten Aussparung (309), die im Plättchen (301) der Einheit vorgesehen ist.

3. Einheit nach Anspruch 2, dadurch gekennzeichnet, dass:
- eines der Sperrmittel (309, 403) eine nach vorn konvergierende Form besitzt und
- dass die Befestigungsvorrichtung (401) ein Gewinde (402) aufweist, das mit einer Schraube (151) zur Befestigung einer der Einheit (130) zugeordneten Klemmleiste (150) zusammenarbeitet, wobei das Gewinde (402) im Verhältnis zur Karte so angeordnet ist, dass durch Einschrauben der Schraube (151) ein hinterer Anschlag der Klemmleiste gegen die Einheit geklemmt wird und die Vorderseite der Karte gegen besagte Einheit zum Anschlag kommt.

4. Einheit nach einem der vorhergehenden Ansprüche, dadurch gekennzeichnet, dass besagtes Bodenteil (304) mindestens ein Durchgangsfenster (312) für einen hinteren Verbinder (600) aufweist, der in die hinteren Verbindungen der Karte eingesteckt werden kann, wobei die Hinterseite des Bodenteils mit dem Fenster (312) fluchtende Auflageflächen für die entsprechenden Flächen des hinteren Verbinders (600) aufweist, sowie Mittel zum Festhalten des besagten hinteren Verbinders (600).

5. Einheit nach Anspruch 4, dadurch gekennzeichnet, dass das im Bodenteil (304) angeordnete Durchgangsfenster (312) breiter und höher ist, als der hintere Verbinder (600) und dass besagte Festhaltemittel es ermöglichen, den hinteren Verbinder in Stellung zu halten, nachdem er in die Karte (400) eingesteckt worden ist.

6. Einheit nach einem der Ansprüche 4 und 5, dadurch gekennzeichnet, dass besagte Festhaltemittel von einer biegsamen Drucklamelle (700) gebildet werden, die in eine Behausung mit bogenförmiger Aussparung (319, 120) der hinteren Flächen der Einheit eingeführt werden kann.

7. Einheit nach einem der Ansprüche 4 bis 6, dadurch gekennzeichnet, dass der hintere Verbinder (600) auf einen flachen mehradrigen Bus (601) montiert ist.

8. Einheit nach einem der vorhergehenden Ansprüche, dadurch gekennzeichnet, dass besagte Seitenteile (302) mit den Seitenrändern des Plättchens (301) durch Scharnierverbindungen verbunden sind.

9. Einheit nach Anspruch 8, dadurch gekennzeichnet, dass sie aus Plastikmaterial geformt ist und dass besagte Scharnierverbindungen (305) biegsame angeformte Verbindungslaschen oder Linien geringerer Stärke sind.

10. Einheit nach einem der Ansprüche 6 und 7, dadurch gekennzeichnet, dass die Seitenflächen (302) senkrecht im Verhältnis zum Plättchen gehalten werden, durch eine Sperrvorrichtung, die zwischen dem Bodenteil (304) und den Seitenrändern der besagtem Bodenteil benachbarten Seitenflächen angeordnet ist.

11. Einheit nach einem der vorhergehenden Ansprüche, dadurch gekennzeichnet, dass die ausserdem eine aus einem Metallblech bestehende Abschirmung (200) aufweist, mit einer ebenen Fläche (201), welche besagtes Plättchen (301) bedeckt und zwei im rechten Winkel gebogenen Seitenschenkeln, welche besagte Seitenflächen (302) überlappen, wobei die Abschirmung (200) ausserdem Mittel zum Zusammenfügen der besagten Einheit durch Ineinanderschieben aufweist.

12. Einheit nach Anspruch 11, dadurch gekennzeichnet, dass die ebene Fläche der Abschirmung (200) Ausschnitte enthält, in denen auf der Aussenseite des besagten Plättchens vorgesehene Sperrklinken (311) einrasten, wenn der Zusammenbau beendet ist.

**Claims**

1. A modular cell for supporting and protecting electronic cards comprising, on the one hand, a flat element or blank (301) having two parallel side edge portions, a front edge portion and a rear edge portion and, on the other hand, extending perpendicularly to said blank from its rear edge portion and from its two lateral edge portions, respectively a bottom (304) and two lateral sides (302) having card guide means forming two respectively opposite slides (303) parallel to the blank (301) and at a small distance therefrom, the spacing of these two slides (303) being provided so that the cards may be engaged therein by two of their opposite lateral edge portions and may slide therein, further comprising fixing means for holding said card in position, once the card has reached its position of use inside the cell at the end of its sliding travel in said slides (303), characterized in that said fixing means comprise snap fit means (309) provided on the blank (301) and cooperating with corresponding snap fit means (403) provided on or added to the card (400), said snap fit means (309, 403) being adapted so as to provide self centering and positional fixing of the card on said blank.

2. The cell as claimed in claim 1, characterized in that said snap fit means (309), (403) are formed by a catch (403) provided on a fixing block (401) added to the card and a recess (309) of corresponding shape provided in the blank (301) of the cell.

3. The cell as claimed in claim 2, characterized in that :
- one of the snap fit means (309, 403) has a shape convergent towards the front, and
- the fixing block (401) comprises a threaded portion (402) provided for cooperating with a screw (151) fixing a terminal strip (150) associated with the cell (130), the threaded portion (402) being positioned with respect to the card so that tightening of the screw (151) causes rear abutment engagement of the terminal strip against the cell and front abutment engagement of the card against the cell.

4. The cell as claimed in one of the preceding claims, characterized in that said bottom (304) comprises at least one window (312) for passing therethrough a rear connector (600) pluggable into the rear connections of the card, the rear face of said bottom having, in line with the window (312), bearing surfaces for corresponding faces of the rear connector (600) as well as means for securing said rear connector (600).

5. The cell as claimed in claim 4, characterized in that the passage window (312) formed in said bottom (304) has a width and a height greater than that of the rear connector (600) and in that said securing means are adapted so as to secure the rear connector once it is plugged on the card (400).

6. The cell as claimed in one of claims 4 and 5, characterized in that said securing means are formed by a resilient pressure blade (700) engageable in an indented housing (319, 120) in the rear face of the cell.

7. The cell as claimed in one of claims 4 to 6, characterized in that the rear connector (600) is mounted on a flat multiconductor bus (601).

8. The cell as claimed in one of the preceding claims, characterized in that said lateral sides (302) are joined to the lateral edge portions of the blank (301) by means of hinge connections (305).

9. The cell as claimed in claim 8, characterized in that it is made from a molded plastic material and in that said hinge means (305) consist of flexible integrally molded connecting lugs or from lines of lesser thickness.

10. The cell as claimed in one of claims 6 and 7, characterized in that said lateral sides (302) are held in position perpendicularly to the blank by means of a snap fit device provided between the bottom (304) and the lateral edge portions of the lateral sides adjacent said bottom (304).

11. The cell as claimed in one of the preceding claims, characterized in that it further comprises a shield (200) formed by a piece of sheet metal having a flat face (201) covering said blank (301) and two lateral wings bent at right angles and coming back over said lateral sides (302), said shield (200) further comprising means for assembly by sliding of said cell.

12. The cell as claimed in claim 11, characterized in that the flat face of the shield (200) comprises cut outs in which catches (311) provided on the outer face of said blank are snap fitted at the end of assembly.

FIG.1

FIG.2

FIG.3

FIG.4

FIG.5

FIG. 6

FIG. 7

FIG. 8

FIG. 9

FIG. 10

FIG. 11